# EUROPEAN PATENT APPLICATION

(11) **EP 4 513 121 A1**
(43) Date of publication of application: **26.02.2025**
(21) Application number: 24196284.4
(22) Date of filing: 23.08.2024
(51) Int. Cl.: F28D 1/02, F28D 1/04, F28D 7/00, F28D 7/10, F25B 23/00, F28D 21/00

(54) **MULTI-MODE COOLING METHOD FOR HEAT SOURCE AND A RESPECTIVE SYSTEM**

(30) Priority: 25.08.2023 US 202363534713 P
(71) Applicant: RTX Corporation, Farmington, CT 06032 (US)
(72) Inventor: IKEDA, Michael K., West Hartford, CT 06117 (US)
(74) Representative: Dehns

(57) **Abstract**

A method of operation is provided during which heat energy is transferred into a first heat exchange fluid during a first mode of operation and during a second mode of operation. The first heat exchange fluid is directed through a first flowpath (36) of a heat exchanger (30) during the first mode of operation and during the second mode of operation. A second heat exchange fluid is directed through a second flowpath (40) of the heat exchanger (30) during the first mode of operation. At least some of the heat energy is transferred from the first heat exchange fluid into the second heat exchange fluid. A third heat exchange fluid is directed through a third flowpath (48) of the heat exchanger (30) during the second mode of operation. At least some of the heat energy is transferred from the first heat exchange fluid into the third heat exchange fluid.

## Description

### BACKGROUND OF THE INVENTION

### 1. Technical Field

This invention relates generally to cooling and, more particularly, to providing backup and/or emergency cooling.

### 2. Background Information

Various cooling systems and methods are known in the art. Some of these cooling systems and methods are capable of providing backup and/or emergency cooling capabilities. While these known cooling systems and methods have various benefits, there is still room in the art for improvement.

### SUMMARY OF THE INVENTION

According to an aspect of the present invention, a method of operation is provided during which heat energy is transferred into a first heat exchange fluid during a first mode of operation and during a second mode of operation. The first heat exchange fluid is directed through a first flowpath of a heat exchanger during the first mode of operation and during the second mode of operation. A second heat exchange fluid is directed through a second flowpath of the heat exchanger during the first mode of operation. At least some of the heat energy is transferred from the first heat exchange fluid into the second heat exchange fluid. A third heat exchange fluid is directed through a third flowpath of the heat exchanger during the second mode of operation. At least some of the heat energy is transferred from the first heat exchange fluid into the third heat exchange fluid.

According to another aspect of the present invention, another method of operation is provided during which heat energy is transferred from a heat source into a first heat exchange fluid during a first mode of operation and during a second mode of operation. The first heat exchange fluid is circulated through a heat exchange circuit during the first mode of operation and during the second mode of operation. The heat exchange circuit passes through a liquid-to-liquid heat exchanger and through a liquid-to-air heat exchanger. At least some of the heat energy is extracted from the first heat exchange fluid using the liquid-to-liquid heat exchanger during the first mode of operation. At least some of the heat energy is extracted from the first heat exchange fluid using the liquid-to-air heat exchanger during the second mode of operation. An air mover for the liquid-to-air heat exchanger is operational during the second mode of operation and non-operational during the first mode of operation.

According to another aspect of the present invention, a system is provided which includes a heat source, a first heat exchange circuit, a second heat exchange circuit and a third heat exchange circuit. The first heat exchange circuit includes a first heat exchange fluid and a first flowpath of a heat exchanger. The first heat exchange circuit is configured to transfer heat energy generated by the heat source into the first heat exchange fluid and direct the first heat exchange fluid through the first flowpath of the heat exchanger during a first mode of operation and during a second mode of operation. The second heat exchange circuit includes a second heat exchange fluid and a second flowpath of the heat exchanger. The second heat exchanger circuit is configured to direct the second heat exchange fluid through the second flowpath of the heat exchanger during the first mode of operation and transfer at least some of the heat energy from the first heat exchange fluid to the second heat exchange fluid. The third heat exchange circuit includes a third flowpath of the heat exchanger. The third heat exchanger circuit is configured to direct a third heat exchange fluid through the third flowpath of the heat exchanger during the second mode of operation and transfer at least some of the heat energy from the first heat exchange fluid to the third heat exchange fluid.

The following optional features may be applied to any of the above aspects.

Flow of the second heat exchanger fluid may be (e.g., intentionally) stopped or severed during the second mode of operation.

The heat exchanger may be configured as a liquid-to-liquid heat exchanger during the first mode of operation. The heat exchanger may be configured as a liquid-to-air heat exchanger during the second mode of operation.

The system may also include an air mover. The third heat exchange fluid may be directed through the third flowpath of the heat exchanger using the air mover.

The system may also include a battery configured to electrically power operation of the air mover during the second mode of operation.

The system may also include a pump and a thermoelectric generator. The first heat exchange fluid may be directed through the first flowpath of the heat exchanger using the pump. The thermoelectric generator may be thermally powered by the heat source. The thermoelectric generator may be configured to electrically power the air mover and the pump during the second mode of operation.

The liquid-to-liquid heat exchanger and the liquid-to-air heat exchanger may be integrated with one another in a common heat exchanger.

The first heat exchange fluid may be a liquid heat exchange fluid.

The second heat exchange fluid may be a liquid heat exchange fluid.

The third heat exchange fluid may be air.

The method may also include circulating the second heat exchange fluid through a heat exchange circuit. The first mode of operation may be a normal mode of operation for the heat exchange circuit. The second mode of operation may be a backup mode of operation for the heat exchange circuit.

The third heat exchange fluid may be directed through the third flowpath of the heat exchanger using an air mover.

The first heat exchange fluid may be directed through the first flowpath of the heat exchanger using a pump or a compressor.

The method may also include powering an air mover and a pump using a common power source. The third heat exchange fluid may be directed through the third flowpath of the heat exchanger using the air mover. The first heat exchange fluid may be directed through the first flowpath of the heat exchanger using the pump.

The common power source may be configured as or otherwise include a battery.

The method may also include generating the heat energy with a heat source. The heat energy may be transferred from the heat source into the first heat exchange fluid during the first mode of operation and during the second mode of operation. The common power source may be configured as or otherwise include a thermoelectric generator thermally powered by the heat source.

The common power source may be configured as or otherwise include an external power source.

The second heat exchange fluid may not be directed through the second flowpath of the heat exchanger during the second mode of operation.

The method may also include cutting power to a pump during the second mode of operation. The second heat exchange fluid may be directed through the second flowpath of the heat exchanger using the pump during the first mode of operation.

The third heat exchange fluid may not be directed through the third flowpath of the heat exchanger during the first mode of operation.

The method may also include cutting power to an air mover during the first mode of operation. The third heat exchange fluid may be directed through the third flowpath of the heat exchanger by the air mover during the second mode of operation.

The method may also include operating an aircraft powerplant. The heat energy may be generated during the operation of the aircraft powerplant.

The present invention may include any one or more of the individual features disclosed above and/or below alone or in any combination thereof.

The foregoing features and the operation of the invention will become more apparent in light of the following description and the accompanying drawings.

### BRIEF DESCRIPTION OF THE DRAWINGS

FIG. 1 is a schematic illustration of a system with a mechanical load and a powerplant.
FIG. 2A is a schematic illustration of a heat source and a heat exchanger system of the powerplant with a closed-loop heat exchange circuit.
FIG. 2B is a schematic illustration of the heat source and the heat exchanger system of the powerplant with an open-loop heat exchange circuit.
FIGS. 3 and 4 are partial perspective illustrations of various heat exchanger arrangements.

### DETAILED DESCRIPTION

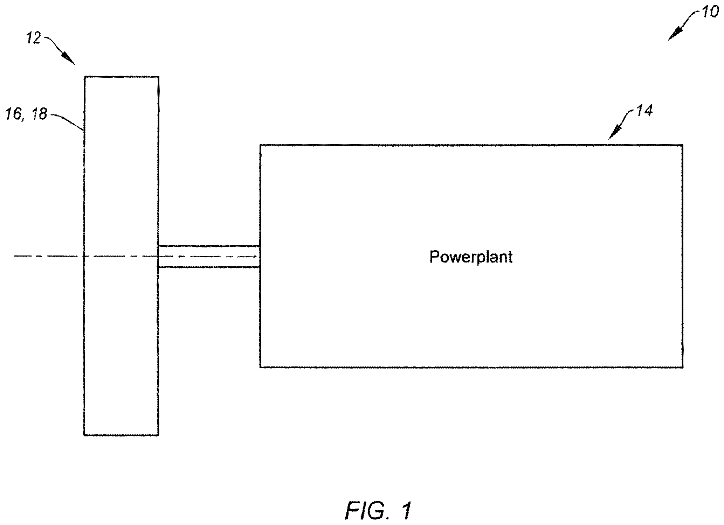

FIG. 1 illustrates a system 10 for an aircraft. The aircraft may be an airplane, a helicopter, a drone (e.g., an unmanned aerial vehicle (UAV)) or any other manned or unmanned aerial vehicle or system. The system 10 may be configured as, or otherwise included as part of, a propulsion system for the aircraft. The system 10 may also or alternatively be configured as, or otherwise included as part of, an electrical power system for the aircraft. The present invention, however, is not limited to aircraft applications nor to propulsion and/or power generation. The system 10, for example, may alternatively be configured to propel and/or power a land vehicle, an aquatic vehicle or any other mobile device. The system 10 may alternatively be configured as a stationary electrical power system. The system 10 may still alternatively be configured as or otherwise include an electronics system (e.g., a processing system, a sensor system, an imaging system, a data storage system, etc.) or any other system which generates heat to be extracted during operation. For ease of description, however, the system 10 of FIG. 1 is generally described below as an aircraft system.

The aircraft system 10 of FIG. 1 includes a mechanical load 12 and a powerplant 14 configured to power operation of the mechanical load 12. The mechanical load 12 of FIG. 1 includes at least one driven rotor 16. This driven rotor 16 may be a bladed propulsor rotor 18 (e.g., an air mover) where the aircraft system 10 is (or is part of) the aircraft propulsion system. The propulsor rotor 18 includes a plurality of rotor blades arranged circumferentially around and connected to at least (or only) one rotor base (e.g., a disk or a hub). The propulsor rotor 18 may be an open (e.g., un-ducted) propulsor rotor or a ducted propulsor rotor. Examples of the open propulsor rotor include a propeller rotor for a propeller propulsion system, a rotorcraft rotor (e.g., a main helicopter rotor) for a rotorcraft propulsion system, a propfan rotor for a propfan propulsion system, and a pusher fan rotor for a pusher fan propulsion system. An example of the ducted propulsor rotor is a fan rotor for a ducted fan propulsion system. The present invention, however, is not limited to the foregoing exemplary propulsor rotor arrangements. Moreover, the driven rotor 16 may alternatively be a generator rotor of an electric power generator where the aircraft system 10 is (or is part of) the aircraft electric power system; e.g., an auxiliary power unit (APU) for the aircraft.

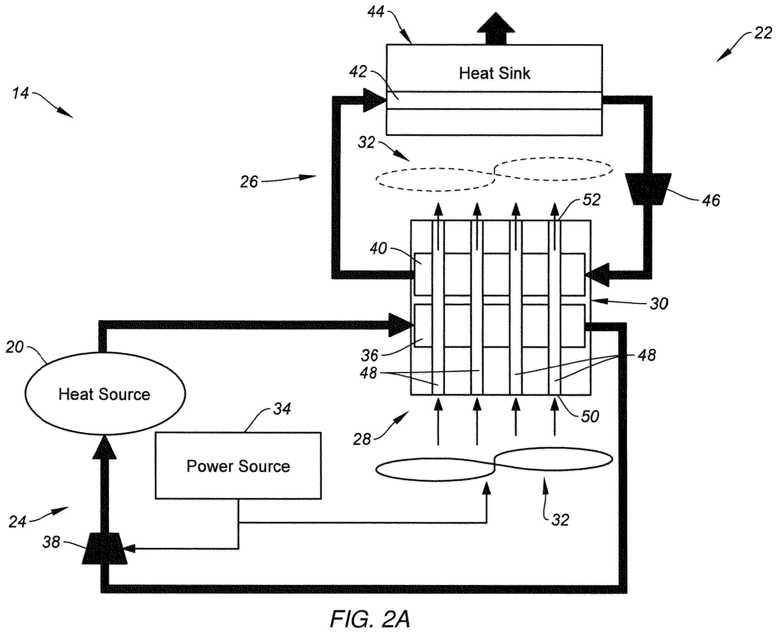

Referring to FIG. 2A, the powerplant includes a heat source 20, a heat exchange system 22 and a heat extraction system 44. The heat source 20 may be configured as a power source for the heat extraction system 44; e.g., a heat sink. The heat source 20, for example, may be configured as or otherwise include a reactor with a radio isotope. Alternatively, the heat source 20 may be configured as or otherwise include an internal combustion engine; e.g., a gas turbine engine, a reciprocating piston engine, a rotary (e.g., Wankel cycle) engine, etc. Still alternatively, where the system 10 is alternatively configured as or otherwise includes the electronics system, the heat source 20 may be configured as an electronics device or grouping of electronic devices. Examples of the electronics device(s) include, but are not limited to, a computer, a server, a memory storage, a signal and/or power switching device, a transformer, flight avionics, aerospace mission systems, etc.

The heat exchange system 22 of FIG. 2A includes a heat source heat exchange circuit 24 ("HS circuit"), a first cooling heat exchange circuit 26 ("first cooling circuit"), and a second cooling heat exchange circuit 28 ("second cooling circuit"). The heat exchange system 22 of FIG. 2A also includes a heat exchanger 30, an air mover 32 and an electrical power source 34.

The HS circuit 24 of FIG. 2A is configured as a closed-loop heat exchange circuit. The HS circuit 24 includes a heat source circuit heat exchange fluid ("HS fluid"), a heat source circuit flowpath 36 ("HS flowpath") of the heat exchanger 30, and a heat source circuit fluid flow regulator 38 ("HS flow regulator"). The HS fluid may be a gas or liquid heat exchange fluid such as, but not limited to, coolant, lubricant, refrigerant, air, or the like. The HS flowpath 36 extends through and/or around the heat exchanger 30. The HS flow regulator 38 is configured to facilitate circulation of the HS fluid through the HS circuit 24 and its HS flowpath 36. The HS flow regulator 38 of FIG. 2A, for example, is configured as an electric pump and/or an electric compressor. The HS circuit 24 of FIG. 2A is also thermally coupled with the heat source 20. More particularly, the HS circuit 24 is configured to facilitate direct or indirect heat transfer between one or more components of the heat source 20 and the HS fluid. The HS circuit 24, for example, may extend through and/or around the heat source 20, where the HS circuit 24 is in thermal contact with (or includes a portion of) the heat source 20. Alternatively, the HS circuit 24 may extend through and/or around another heat exchanger thermally coupled to the heat source 20.

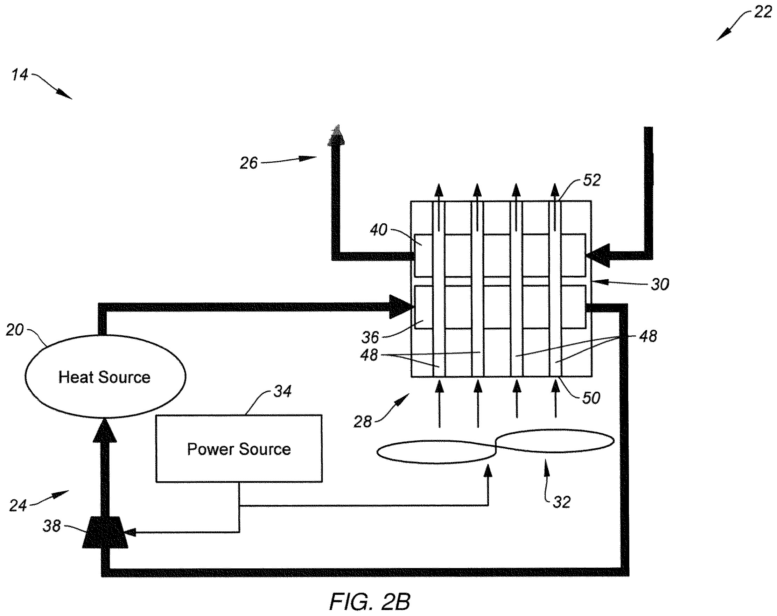

The first cooling circuit 26 of FIG. 2A is configured as a closed-loop heat exchange circuit. In other embodiments, referring to FIG. 2B, the first cooling circuit 26 may alternatively be configured as an open-loop circuit. Referring again to FIG. 2A, the first cooling circuit 26 includes a first cooling circuit heat exchange fluid ("first cooling fluid"), a first cooling circuit flowpath 40 ("first cooling flowpath") of the heat exchanger 30, a first cooling circuit flowpath 42 of the heat extraction system 44 ("extraction system flowpath"), and a first cooling circuit fluid flow regulator 46 ("cooling circuit flow regulator"); e.g., a pump and/or a compressor. The first cooling fluid may be a gas or liquid heat exchange fluid such as, but not limited to, refrigerant, air, coolant, lubricant or the like. This first cooling fluid may have the same composition as the HS fluid, or may have a different composition than the HS fluid. The first cooling flowpath 40 extends through the heat exchanger 30. The extraction system flowpath 42 extends through and/or around the heat extraction system 44. This heat extraction system 44 may be configured as or otherwise include another heat exchanger (e.g., a radiator, a liquid-to-liquid heat exchanger, etc.), an energy extracting turbine, or another component or system of the powerplant 14 (e.g., a bottoming cycle system, etc.). The cooling circuit flow regulator 46 is configured to facilitate circulation of the first cooling fluid through the first cooling circuit 26 and its first cooling flowpath 40 and its extraction system flowpath 42. In the case of an open loop configuration, the flowpath for the first cooling circuit 26 of FIG. 2B may initiate from an external reservoir (e.g., atmosphere, water body, etc.) and enter the cooling loop through the cooling circuit flow regulator 46 and eventually terminate by rejection of the fluid back to the reservoir after passing through the energy extraction system through flowpath 42.

The second cooling circuit 28 of FIG. 2A is configured as an open-loop heat exchange circuit. The second cooling circuit 28 includes a second cooling circuit flowpath 48 ("second cooling flowpath") of the heat exchanger 30. This second cooling flowpath 48 extends through and/or around the heat exchanger 30 between an inlet 50 into the second cooling circuit 28 and an outlet 52 from the second cooling circuit 28. The cooling circuit inlet 50 and/or the cooling circuit outlet 52 may each be fluidly coupled to an environment external to the aircraft system 10; e.g., ambient air. The cooling circuit inlet 50, however, may alternatively be fluidly coupled with another cooling fluid source such as, but not limited to, a bypass flowpath, a powerplant compressor, etc.

The heat exchanger 30 may be configured as a single, unitary structure. The HS flowpath 36 may be configured as or otherwise include one or more internal passages in and/or through the heat exchanger 30. The first cooling flowpath 40 may be configured as or otherwise include one or more internal passages in and/or through the heat exchanger 30. The second cooling flowpath 48 may be configured as or otherwise include one or more internal passages in and/or through the heat exchanger 30. Some or all of the passages in each flowpath 36, 40, 48 may be fluidly discrete from one another (e.g., the passages may be fluidly coupled in parallel). Some or all of the passages in each flowpath 36, 40, 48 may also or alternatively be interconnected along their lengths. The passage(s) of the HS flowpath 36, however, are fluidly decoupled from (a) the first cooling circuit 26 and the passage(s) of its first cooling flowpath 40 and (b) the second cooling circuit 28 and the passage(s) of its second cooling flowpath 48. The passage(s) of the first cooling flowpath 40 are similarly fluidly decoupled from the second cooling circuit 28 and the passage(s) of its second cooling flowpath 48. With this arrangement, the heat exchanger 30 may be configured as a liquid-to-liquid heat exchanger when the liquid HS fluid flows through the HS flowpath 36 and the liquid first cooling fluid flows through the first cooling flowpath 40. The heat exchanger 30 may be configured as a liquid-to-gas heat exchanger (e.g., a radiator) when the liquid HS fluid flows through the HS flowpath 36 and the gaseous second cooling fluid flows through the second cooling flowpath 48. Of course, it is contemplated that different combinations of liquid-to-liquid, liquid-to-gas, gas-to-liquid or gas-to-gas may be utilized for exchanging heat energy. Combining the various heat exchanger flowpaths 36, 40 and 48 into the common heat exchanger 30 may maximize operability of the heat exchanger 30 while reducing space requirements for the heat exchange system 22. This would otherwise require two separate dedicated heat exchangers, one to heat exchanger to exchange heat energy between the HS fluid flow and the first cooling fluid and another separate heat exchanger to exchange heat energy between the HS fluid flow and the second cooling fluid.

The air mover 32 is arranged with the heat exchanger 30 and the second cooling circuit 28. This air mover 32 is configured to direct a second cooling circuit heat exchange fluid ("second cooling fluid") such as air (e.g., ambient air, compressor bleed air, fan bleed air, etc.) through the second cooling flowpath 48. The air mover 32 of FIG. 2A, for example, is positioned in front of or otherwise upstream of the cooling circuit inlet 50. With this arrangement, the air mover 32 may push the air into and through the second cooling circuit 28. The air mover 32, however, may alternatively be positioned in back of or otherwise downstream of the cooling circuit outlet 52 (see dashed line air mover 32). With this arrangement, the air mover 32 may generate suction to pull the air into and through the second cooling circuit 28. The air mover 32 of FIG. 2A is configured as an electric fan.

The power source 34 is configured to electrically power one or more components of the powerplant 14. The power source 34 of FIG. 2A, for example, is electrically coupled to the HS flow regulator 38 and/or the air mover 32. The power source 34 may be configured as or otherwise include one or more power storage devices; e.g., batteries, supercapacitors, etc. The power source 34 may also or alternatively be configured as or otherwise include a thermoelectric generator thermally coupled to and powered by the heat source 20 (or another heat source). The power source 34 may also or alternatively be connected to another external power source. The present invention, however, is not limited to the foregoing exemplary power source configurations.

During aircraft system operation, the powerplant 14 of FIG. 1 may be operated to drive rotation of the driven rotor 16. During this powerplant operation, the heat source 20 of FIG. 2A generates heat energy. Some of the heat energy may be converted into mechanical power and/or electrical power by the heat source 20 or, more generally, the powerplant 14. At least some of the heat energy (e.g., waste heat energy), however, may be extracted from the heat source 20 to maintain the heat source 20 within an operational temperature range and/or below a (e.g., maximum) operational temperature threshold.

The heat exchange system 22 of FIG. 2A may be operated in various modes of operation. During each of these operating modes, the HS fluid is directed (e.g., circulated) within the HS circuit 24 to facilitate transfer of at least some of the heat energy generated by the heat source 20 from the heat source 20 into the HS fluid. At least some or all of the heat energy transferred into the HS fluid may subsequently be extracted from the HS fluid using the heat exchanger 30. In this manner, the heat source 20 may be maintained within its operational temperature range and/or below its operational temperature threshold.

During a first circuit mode of operation, the heat exchange system 22 operates the first cooling circuit 26. The cooling circuit flow regulator 46, for example, directs (e.g., circulates) the first cooling fluid within the first cooling circuit 26. As the first cooling fluid flows in the first cooling flowpath 40, the heat exchanger 30 transfers at least some of the heat energy from the HS fluid into the first cooling fluid. This heated first cooling fluid is subsequently directed into the heat extraction system 44. As the first cooling fluid flows in the extraction system flowpath 42, the heat extraction system 44 extracts at least some of the heat energy from the first cooling fluid. For example, where the heat extraction system 44 is a radiator, the radiator may transfer the heat energy from the first cooling fluid into the ambient air around and/or passing through the radiator. In this manner, the heat exchange system 22 and its first cooling circuit 26 may reject heat energy extracted from the heat source 20, for example, to ambient. During this first circuit operating mode, the second cooling circuit 28 may be substantially non-operational. The air mover 32, for example, may be non-operational such that the second cooling fluid is not actively directed through the second cooling flowpath 48.

The first circuit operating mode may be implemented when the heat exchange system 22 and its first cooling circuit 26 are (e.g., fully) operational and/or can (e.g., completely) satisfy heat extraction needs of the heat source 20. This first circuit operating mode may thereby be a normal mode of operation for the heat exchange system 22 and its first cooling circuit 26. However, under certain conditions and/or due to a failure in one or more components of the first cooling circuit 26, or due to accidental or intentional severing of the first cooling flow circuit lines, the first cooling circuit 26 may become non-operational. Severing may occur intentionally to break the coupling between the HS flow and the first cooling flow loop. To prevent or reduce overheating of the heat source 20, the heat exchange system 22 may operate its second cooling circuit 28 in a second circuit mode of operation. This second circuit operating mode may thereby be a backup or emergency mode of operation for the heat exchange system 22 and its first cooling circuit 26. The foregoing operability may be useful for a heat source that continuously generates heat energy (e.g., via radioisotope decay) or for a heat source that is sensitive to temperature overruns (e.g., a cocooned gas turbine engine in a combined cycle ,or sensitive electronics that are continuously cooled even if the first cooling flow loop becomes inoperable).

During the second circuit operating mode, the air mover 32 is powered up and directs the second cooling fluid within (e.g., through) the second cooling circuit 28 and through its second cooling flowpath 48. As the second cooling fluid flows in the second cooling flowpath 48, the heat exchanger 30 transfers at least some of the heat energy from the HS fluid into the second cooling fluid. This heated second cooling fluid is subsequently directed into the surrounding environment. In this manner, the heat exchange system 22 and its second cooling circuit 28 may reject heat energy extracted from the heat source 20, for example, to ambient. During this second circuit operating mode, the first cooling circuit 26 may be substantially non-operational. The cooling circuit flow regulator 46, for example, may be non-operational such that the first cooling fluid is not actively directed through the first cooling flowpath 40 and/or otherwise circulated within the first cooling circuit 26.

Under certain conditions, an operational capacity of the first cooling circuit 26 may be diminished and/or may no longer satisfy the heat extraction needs of the heat source 20 (e.g., alone). To prevent or reduce overheating of the heat source 20, the heat exchange system 22 may operate both its first cooling circuit 26 and its second cooling circuit 28 in a multi-circuit mode of operation. During this multi-circuit operating mode, the first cooling circuit 26 and the second cooling circuit 28 may be utilized together to extract the heat energy from the HS fluid through the heat exchanger 30. For example, the first cooling circuit 26 may be operated as described above for the first circuit operating mode and the second cooling circuit 28 and its associated air mover 32 may be operated as described above for the second circuit operating mode.

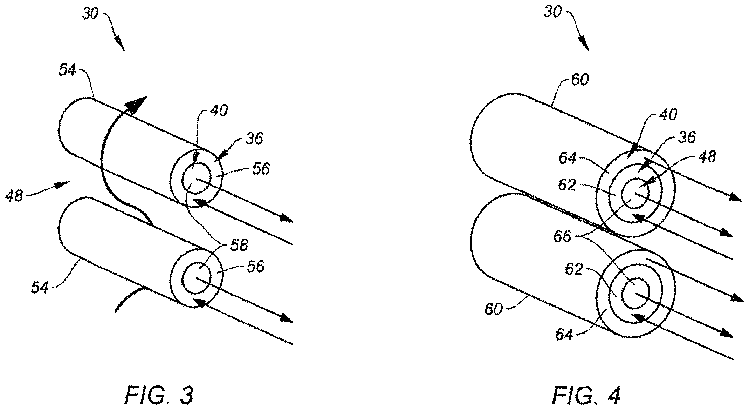

In some embodiments, referring to FIG. 3, the heat exchanger 30 may include one or more double walled tubes 54. Each of these double walled tubes 54 may include a passage 56 for the HS flowpath 36 and a passage 58 for the first cooling flowpath 40. The HS flowpath passage 56 of FIG. 3 is radially outboard of and may circumscribe the respective first cooling flowpath passage 58. The second cooling flowpath 48 of FIG. 3 is formed by a plenum surrounding the double walled tubes 54. Alternatively, the HS flowpath 36 may pass through the HS passage 36 while the passage 58 is used for the second cooling flowpath 48 and the second cooling flowpath 48 is used for the first cooling flowpath. In this mode, when the first cooling path is operating (e.g., during a normal operating mode), the heat exchanger 30 has a shell tube configuration and when the second cooling path is enabled, a tube in tube arrangement would transfer heat from the HS flowpath to the second cooling flow path. All three flowpaths could be arranged in cross, counter, or parallel flow arrangements, depending on the specifics of the application conditions and the fluids used.

In some embodiments, referring to FIG. 4, the heat exchanger 30 may include one or more triple walled tubes 60. Each of these triple walled tubes 60 may include a passage 62 for the HS flowpath 36, a passage 64 for the first cooling flowpath 40 and a passage 66 for the second cooling flowpath 48. The HS flowpath passage 62 of FIG. 4 is radially outboard of and may circumscribe the respective second cooling flowpath passage 66. The first cooling flowpath passage 64 of FIG. 4 is radially outboard of and may circumscribe the respective HS flowpath passage 62. In other embodiments, however, a positional arrangement of the first cooling flowpath passage 64 and the second cooling flowpath passage 66 may be reversed. Similarly, the flow direction could be varied based on application requirements. The tubes also need not be circular and may be shaped to best utilize the volume available in the system.

While various embodiments of the present invention have been described, it will be apparent to those of ordinary skill in the art that many more embodiments and implementations are possible within the scope of the invention. For example, the present invention as described herein includes several aspects and embodiments that include particular features. Although these features may be described individually, it is within the scope of the present invention that some or all of these features may be combined with any one of the aspects and remain within the scope of the invention. Accordingly, the present invention is not to be restricted except in light of the attached claims and their equivalents.

## Claims

1. A method of operation comprising:
transferring heat energy into a first heat exchange fluid during a first mode of operation and during a second mode of operation;
directing the first heat exchange fluid through a first flowpath (36) of a heat exchanger (30) during the first mode of operation and during the second mode of operation;
directing a second heat exchange fluid through a second flowpath (40) of the heat exchanger (30) during the first mode of operation, and transferring at least some of the heat energy from the first heat exchange fluid into the second heat exchange fluid; and
directing a third heat exchange fluid through a third flowpath (48) of the heat exchanger (30) during the second mode of operation, and transferring at least some of the heat energy from the first heat exchange fluid into the third heat exchange fluid.

2. The method of claim 1, wherein:
the first heat exchange fluid is a liquid heat exchange fluid;
the second heat exchange fluid is a liquid heat exchange fluid; and/or
the third heat exchange fluid is air.

3. The method of claim 1 or 2, further comprising circulating the second heat exchange fluid through a heat exchange circuit (26), wherein the first mode of operation is a normal mode of operation for the heat exchange circuit (26), and the second mode of operation is a backup mode of operation for the heat exchange circuit (26).

4. The method of any preceding claim, wherein the third heat exchange fluid is directed through the third flowpath (48) of the heat exchanger (30) using a fluid mover (32).

5. The method of any preceding claim, wherein the first heat exchange fluid is directed through the first flowpath (36) of the heat exchanger (30) using a first pump (38) or compressor (38).

6. The method of any preceding claim, further comprising powering an air mover (32) and a or the first pump (38) using a common power source (34), wherein the third heat exchange fluid is directed through the third flowpath (48) of the heat exchanger (30) using the air mover (32), and the first heat exchange fluid is directed through the first flowpath (36) of the heat exchanger (30) using a or the first pump (38), wherein, optionally, the common power source (34) comprises a battery.

7. The method of claim 6, further comprising generating the heat energy with a heat source (20), the heat energy transferred from the heat source (20) into the first heat exchange fluid during the first mode of operation and during the second mode of operation, and the common power source (34) comprising a thermoelectric generator thermally powered by the heat source (20).

8. The method of any preceding claim, further comprising:
cutting power to a second pump (46) during the second mode of operation, wherein the second heat exchange fluid is directed through the second flowpath (40) of the heat exchanger (30) using the second pump (46) during the first mode of operation; and/or
cutting power to an or the air mover (32) during the first mode of operation, wherein the third heat exchange fluid is directed through the third flowpath (48) of the heat exchanger (30) by the air mover (32) during the second mode of operation.

9. The method of any preceding claim, further comprising operating an aircraft powerplant (14), wherein the heat energy is generated during the operation of the aircraft powerplant (14).

10. A method of operation, comprising:
transferring heat energy from a heat source (20) into a first heat exchange fluid during a first mode of operation and during a second mode of operation;
circulating the first heat exchange fluid through a heat exchange circuit (24) during the first mode of operation and during the second mode of operation, the heat exchange circuit (24) passing through a liquid-to-liquid heat exchanger (30) and through a liquid-to-air heat exchanger (30);
extracting at least some of the heat energy from the first heat exchange fluid using the liquid-to-liquid heat exchanger (30) during the first mode of operation; and
extracting at least some of the heat energy from the first heat exchange fluid using the liquid-to-air heat exchanger (30) during the second mode of operation, wherein an air mover (32) for the liquid-to-air heat exchanger (30) is operational during the second mode of operation and non-operational during the first mode of operation, wherein, optionally:
the liquid-to-liquid heat exchanger (30) and the liquid-to-air heat exchanger (30) are integrated with one another in a common heat exchanger (30).

11. A system (10), comprising:
a heat source (20);
a first heat exchange circuit (24) including a first heat exchange fluid and a first flowpath (36) of a heat exchanger (30), the first heat exchange circuit (24) configured to transfer heat energy generated by the heat source (20) into the first heat exchange fluid and direct the first heat exchange fluid through the first flowpath (36) of the heat exchanger (30) during a first mode of operation and during a second mode of operation;
a second heat exchange circuit (26) including a second heat exchange fluid and a second flowpath (4) of the heat exchanger (30), the second heat exchange circuit (26) configured to direct the second heat exchange fluid through the second flowpath (40) of the heat exchanger (30) during the first mode of operation and transfer at least some of the heat energy from the first heat exchange fluid to the second heat exchange fluid; and
a third heat exchange circuit (28) comprising a third flowpath (48) of the heat exchanger (30), the third heat exchange circuit (28) configured to direct a third heat exchange fluid through the third flowpath (48) of the heat exchanger (30) during the second mode of operation and transfer at least some of the heat energy from the first heat exchange fluid to the third heat exchange fluid.

12. The system (10) of claim 11, wherein:
the heat exchanger (30) is configured as a liquid-to-liquid heat exchanger (30) during the first mode of operation; and
the heat exchanger (30) is configured as a liquid-to-air heat exchanger (30) during the second mode of operation.

13. The system (10) of claim 11 or 12, further comprising an air mover (32), wherein the third heat exchange fluid is directed through the third flowpath (48) of the heat exchanger (30) using the air mover (32).

14. The system (10) of claim 13, further comprising a battery (34) configured to electrically power operation of the air mover (32) during the second mode of operation.

15. The system of claim 13 or 14, further comprising a pump (38), wherein the first heat exchange fluid is directed through the first flowpath (48) of the heat exchanger (30) using the pump (38), and a thermoelectric generator (34) thermally powered by the heat source (20), the thermoelectric generator (34) configured to electrically power the air mover (32) and the pump (38) during the second mode of operation.
